# EUROPEAN PATENT SPECIFICATION

(11) **EP 1 670 123 B1**
(45) Date of publication and mention of the grant of the patent: **23.03.2011**
(21) Application number: 05025266.7
(22) Date of filing: 18.11.2005
(51) Int. Cl.: H02K 11/02

(54) **Noise filter and electric motor comprising this filter**
Entstörfilter und Elektromotor mit diesem Entstörfilter
Filtre antiparasites et moteur électrique utilisant un tel filtre

(30) Priority: 29.11.2004 JP 2004344688
(43) Date of publication of application: 14.06.2006
(73) Proprietor: TDK Corporation, Chuo-ku, Tokyo 103-8272 (JP)
(72) Inventor: Togashi, Masaaki, Chuo-ku Tokyo 103-8272 (JP)
(74) Representative: Grünecker, Kinkeldey, Stockmair & Schwanhäusser Anwaltssozietät

(56) References cited:
- US-A- 5 896 267
- US-A- 5 973 906
- PATENT ABSTRACTS OF JAPAN vol. 2003, no. 06, 3 June 2003 (2003-06-03) -& JP 2003 037961 A (MORI YOSHIYUKI), 7 February 2003 (2003-02-07)
- PATENT ABSTRACTS OF JAPAN vol. 007, no. 099 (E-172), 27 April 1983 (1983-04-27) & JP 58 022569 A (MATSUSHITA DENKO KK), 9 February 1983 (1983-02-09)
- PATENT ABSTRACTS OF JAPAN vol. 2000, no. 26, 1 July 2002 (2002-07-01) -& JP 2001 268842 A (ASMO CO LTD), 28 September 2001 (2001-09-28)

## Description

The present invention relates to a noise filter and a motor.

### Related Background of the Invention

In a DC motor, electric noise is generated by contact and separation operations, between brushes and a commutator. A conventional means for removing the electric noise thus generated is to connect a capacitor to each power supply line of the DC motor and to make the capacitor function as a noise filter (e.g., reference is made to Japanese Patent Application Laid-Open No. 2001-268842).

In the motor described in the Laid-Open No. 2001-268842, terminals for brush wiring functioning as power supply lines are extended from brush connection terminals and capacitors are connected to the extended portions of the terminals for brush wiring.

In the motor described in the Laid-Open No. 2001-268842, the capacitors are connected to the extended portions of the terminal for brush wiring, and thus the distance is long between the capacitors and the portions of the terminals for brush wiring next to the brush connection terminates. Namely, the wires between the power supply lines and the capacitors are long in the motor described in the Laid Open No. 2001-268842.

In addition, JP 2003 037961 describes an electric motor wherein the lead wires are connected to a print circuit board that comprises a noise filter.

Incidentally, the capacitors are selected so as to gain a frequency characteristic as noise filters, in view of the frequency band of the electric noise to be removed. However, as the wires become longer between the power supply lines and the capacitors, the wires come to demonstrate greater increase influence of their inductance component and resistance component, which will change the frequency characteristic as the noise filters. This will result in degrading the electric noise removing effect of the noise filters (capacitors).

US 5973906 and US 5896267 describe filters that are mainly designed for implantable medical devices and are directly connected to the lead wires.

An object of the present invention is to provide a motor comprising noise filters demonstrating an excellent effect of removing the electric noise. This is achieved by the features of the claims.

Fig. 1 is a perspective view for explaining a configuration of a noise filter.

Fig. 2 is a schematic diagram for explaining a configuration of a motor according to an embodiment of the present invention.

Fig. 3 is a schematic diagram for explaining a configuration of a motor according to an embodiment of the present invention.

Fig. 4 is a perspective view for explaining a configuration of a noise filter.

Noise filters and the motors according to embodiments of the present invention will be described with reference to the drawings. Identical elements, or elements with identical functionality will be denoted by the same reference symbols throughout the description, without redundant description. It is noted that the terms indicating the directions such as the top, bottom, left, and right are based on the drawings and provided for descriptive purposes only.

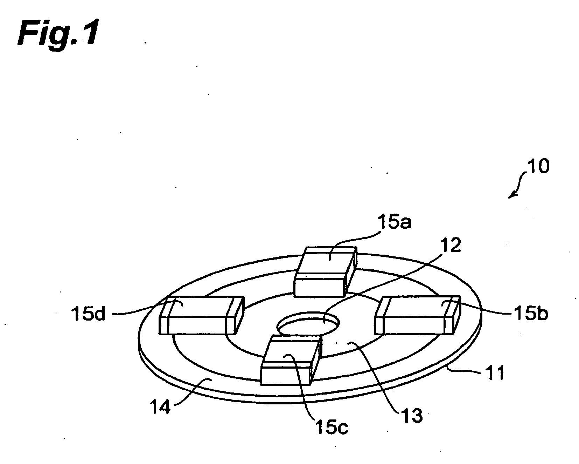

First, noise filter 10 will be described for illustrative purposes with reference to Fig. 1. Fig. 1 is a perspective view for explaining the configuration of noise filter 10. The noise filter 10 comprises a substrate 11 formed with a through hole 12, and a plurality of (four in the present embodiment) capacitors 15a-15d. The substrate 11 has a first conductor pattern 13 and a second conductor pattern 14. The capacitors 15a-15d can be multilayer chip capacitors.

The substrate 11 is a printed circuit board of disk shape, in which the through hole 12 for letting a power supply line of a motor pass is formed in the center. The through hole 12 preferably has a size enough to let the power supply line pass and a shape similar to a sectional shape of the power supply line. The first conductor pattern 13 is located near the through hole 12 and is arranged on a concentric circle so as to surround the through hole 12. The second conductor pattern 14 is electrically insulated from the first conductor pattern 13 and is arranged on a concentric circle so as to surround the first conductor pattern 13. The outer periphery of the second conductor pattern 14 is approximately coincident with the outer periphery of the substrate 11.

Each of the capacitors 15a-15d is arranged on the substrate 11 and is connected in series between the first conductor pattern 13 and the second conductor pattern 14. The capacitors 15a-15d are arranged so as to surround the through hole 12 on the substrate 11.

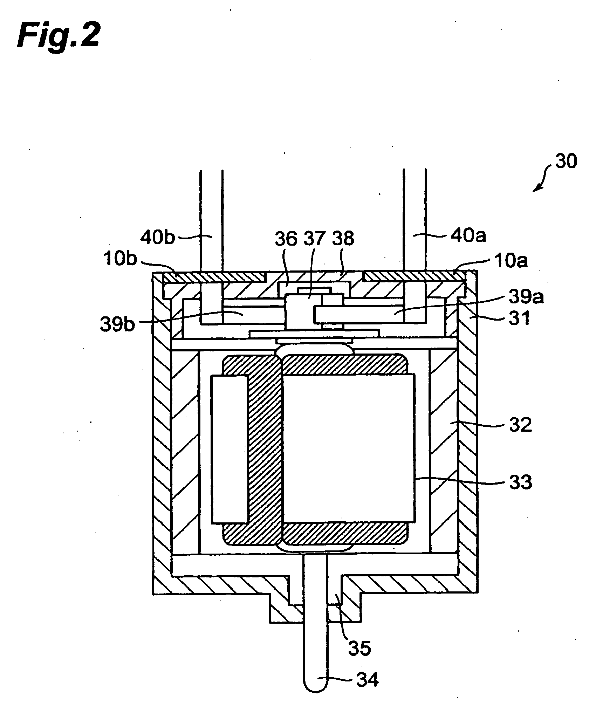

Motor 30 according to an embodiment of the present invention will be described with reference to Fig. 2. Fig. 2 is a schematic diagram for explaining a configuration of a motor according to an embodiment of the present invention. The motor 30 comprises two noise filters 10a, 10b. The configuration of each noise filter 10a, 10b is the same as the above-described noise filter 10, and the description is thus omitted herein about the configuration of the noise filters 10a, 10b.

The motor 30 has a housing 31 formed in a bottomed hollow cylindrical shape. Magnets 32 are attached to an inner peripheral surface of housing 31. Armature 33 is arranged so as to face the magnets 32. A rotor is composed of armature 33, shaft 34, and commutator 37. Bearing 35 fixed to the bottom of housing 31 and bearing 36 fixed to end bracket 38 in the top part of housing 31 rotatably support the shaft 34 forming the rotor. Brush 39a and brush 39b are mounted so as to be kept in sliding contact with the commutator 37. The brush 39a and the brush 39b are electrically connected to power supply lines 40a and 40b, respectively.

The power supply line 40a and the power supply line 40b pass through the respective through holes 12 of the noise filter 10a and the noise filter 10b. The first conductor patterns 13 of the respective noise filters 10a and 10b are electrically connected to the power supply line 40a and to the power supply line 40b, respectively. The electric connections between the power supply lines 40a, 40b and the first conductor patterns 13 can be implemented by soldering, bonding with an electroconductive adhesive, or the like.

The second conductor patterns 14 of the respective noise filters 10a and 10b are electrically connected to each other through a part of their side face in contact with the housing 31. The noise filter 10a and the noise filter 10b are fixed as bonded in and to grooves formed in the top surface of the end bracket 38. The top surface of noise filter 10 is located at the same height as the upper end of housing 31 and the upper face of the end bracket 38. The housing 31 and the second conductor patterns 14 may be electrically connected by soldering, bonding with an electroconductive adhesive, or the like.

Subsequently, the effect of the above embodiments will be described below.

In the noise filters 10 (10a, 10b), the first conductor pattern 13 to which the capacitors 15a-15d are electrically connected is formed near the through hole 12 for the power supply line 40a or 40b to pass, on the substrate 11, and thus the length of wires for electrically connecting the capacitors 15a-15d to the power supply line 40a or 40b is extremely short. For this reason, the wires have the least influence of their inductance component and resistance component, so as to suppress the change in the frequency characteristic of the noise filter due to the inductance component and resistance component. Therefore, it is feasible to achieve a high noise removing effect of noise filter 10.

In addition, the first conductor pattern 13 and the second conductor pattern 14 are arranged on concentric circles so as to surround the through hole 12. This permits the four capacitors 15a-15d to be located in compact arrangement, so as to achieve miniaturization of the noise filter 10. The foregoing embodiments adopt four capacitors 15a-15d, but the number of capacitors 15a-15d can be set corresponding to the frequency of electric noise generated in the motor 30.

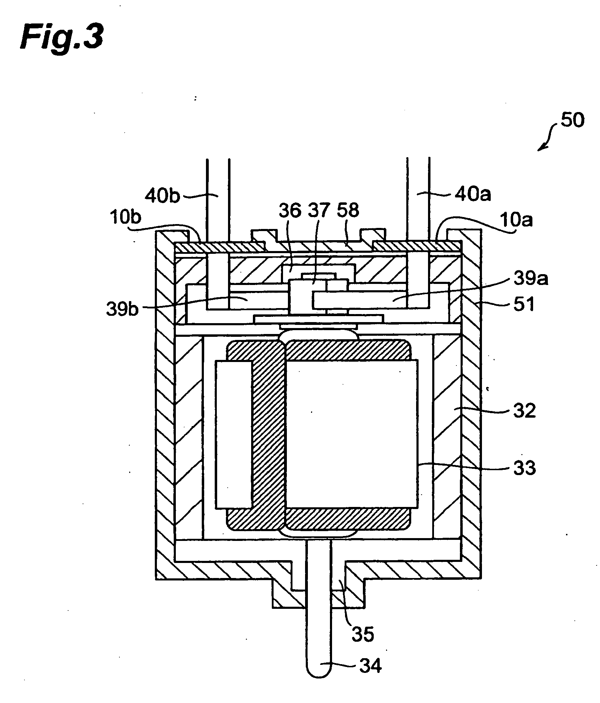

Next, another motor 50 according to an embodiment of the present invention will be described with reference to Fig. 3. Fig. 3 is a schematic diagram for explaining the configuration of motor 30. The motor 50 is different in the mount structure of noise filters 10a, 10b from the above-described motor 30.

In the motor 50, portions of housing 51 and end bracket 58 project to over the noise filters 10a, 10b to fix the noise filters 10a, 10b so as to keep them still in the vertical directions. The configuration except for this difference is the same as the configuration of the aforementioned motor 30, and the description thereof is thus omitted herein.

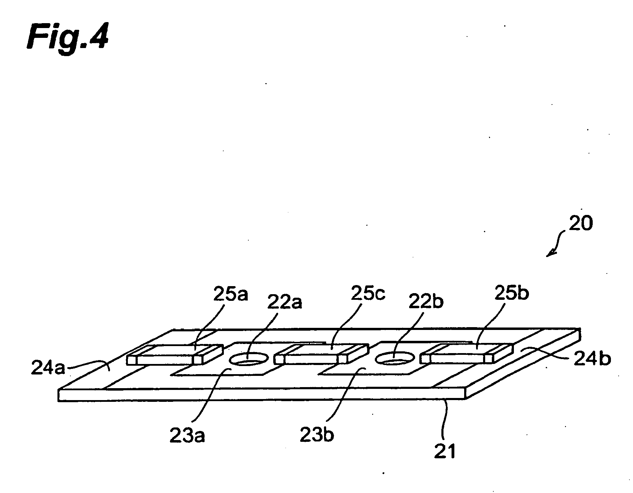

Another noise filter according to an embodiment of the present invention will be described with reference to Fig. 4. Fig. 4 is a perspective view for explaining the configuration of noise filter 20 according to the present embodiment. The noise filter 20 is different from the aforementioned noise filter 10 in that the substrate is formed with two through holes, and has two sets of first conductor patterns and second conductor patterns.

The noise filter 20 comprises a substrate 21 formed with two through holes, and a plurality of (three in the present embodiment) capacitors 25a-25c. The substrate 21 has a first set of first conductor pattern 23a and second conductor pattern 24a, and a second set of first conductor pattern 23b and second conductor pattern 24b. The capacitors 25a-25c can be multilayer chip capacitors.

The substrate 21 is a printed circuit board of rectangular shape, and formed with circular through holes 22a and 22b for letting respective power supply lines of a motor pass. The first conductor pattern 23a and the first conductor pattern 23b are located near the through hole 22a and near the through hole 22b, respectively. The first conductor pattern 23a and the first conductor pattern 23b are arranged to surround the through hole 22a and the through hole 22b, respectively. The first conductor pattern 23a and the first conductor pattern 23b are square and the through hole 22a and the through hole 22b are located in the centers of the respective conductor patterns.

The second conductor pattern 24a and the second conductor pattern 24b are electrically insulated from the first conductor pattern 23a and from the first conductor pattern 23b, respectively. The second conductor pattern 24a is formed in a rectangular shape at an end on the side near the first conductor pattern 23a on the substrate 21. The second conductor pattern 24b is formed in a rectangular shape at the end on the side near the first conductor pattern 23b on the substrate 21. Two sets of through holes 22a, 22b, first conductor patterns 23a, 23b, and second conductor patterns 24a, 24b are arranged in symmetry on the substrate 21.

The capacitors 25a-25c are arranged on the substrate 21. The capacitor 25a is connected in series between the first conductor pattern 23a and the second conductor pattern 24a. The capacitor 25b is connected in series between the first conductor pattern 23b and the second conductor pattern 24b. The capacitor 25c is connected in series between the first conductor pattern 23a and the first conductor pattern 23b.

The noise filter 20 of the present embodiment is also able to demonstrate a high noise removing effect as the aforementioned noise filter 10 was. The noise filter 20 adopts the common substrate 21 to two power supply lines, and each of the capacitors 25a-25c is connected to each power supply line. As a result, it becomes feasible to achieve miniaturization of the noise filter 20.

The noise filter 20 has the capacitor 25c connected in series between the first conductor pattern 23a and the first conductor pattern 23b. This permits the capacitance of the noise filter 20 to be readily adjusted according to the frequency band of the generated electric noise, whereby the electric noise can be removed more effectively.

The above described the preferred embodiments of the present invention, but it is noted that the present invention is not always limited to these embodiments. For example, the shape of each conductor pattern 13, 14, 23a, 23b, 24a, 24b, the number of capacitors 15a-15d, 25a-25c, etc. are not limited to those in each of the above-described embodiments.

## Claims

1. A motor (30;50) comprising a noise filter (10;20), **characterized in that**
the noise filter (10;20) comprises a plane substrate (11;21) formed with a through hole (12;22) for letting a power supply line (40) pass, and a capacitor (15;25) placed on the substrate, wherein the substrate has:
a first conductor pattern (13;23) located near the through hole (12;22) and adapted to be electrically connected to the power supply line (40) to pass through the through hole (12;22), and
a second conductor pattern (14;24) electrically insulated from the first conductor pattern (13;23); wherein the capacitor (15;25) is connected in series between the first conductor pattern (13;23) and the second conductor pattern (14;24),
wherein the noise filter (10;20) is mounted, in such a way that the plane of the substrate is perpendicular to the shaft (34) of the motor (30;50), either in groores formed in the end bracket (38) of the motor (30;50), or to portions of the housing (51) that project inwardly from an axial end of the housing (51) and to the end bracket (58) of the motor.

2. The motor (30;50) according to claim 1, wherein the noise filter (10;20) comprises a plurality of said capacitors (15;25).

3. The motor (30;50) according to any of claims 1 or 2, wherein the first conductor pattern and the second conductor pattern are arranged on concentric circles so as to surround the through hole.

4. The motor (30;50) according to claim 1, wherein the noise filter (20) is configured as follows:
the substrate (21) is formed with two said through holes (22a;22b), and has two sets of said first conductor patterns (23a;23b) and said second conductor patterns (24a;24b),
a first capacitor (25a) is connected in series between the first conductor pattern (23a) and the second conductor pattern (24a) in one set, and
a second capacitor (25b) is connected in series between the first conductor pattern (23b) and the second conductor pattern (24b) in the other set.

5. The motor (30;50) according to claim 4, wherein the noise filter (20) further comprises a capacitor (25c) connected in series between the first conductor pattern (23a) in the one set and the first conductor pattern (23b) in the other set.

## Patentansprüche

1. Motor (30; 50), der ein Entstörfilter (10;20) umfasst, **dadurch gekennzeichnet, dass**
das Entstörfilter (10; 20) ein planes Substrat (11; 21), das mit einem Durchgangsloch (12; 22) zum Hindurchlassen einer Stromzuführleitung (40) versehen ist, und einen Kondensator (15; 25) umfasst, der auf dem Substrat angeordnet ist, wobei das Substrat aufweist:
ein erstes Leitermuster (13; 23), das sich nahe an dem Durchgangsloch (12; 22) befindet und so eingerichtet ist, dass es mit der Stromzuführleitung (40) elektrisch verbunden ist, um durch das Durchgangsloch (12; 22) hindurchzutreten, und
ein zweites Leitermuster (14; 24), das gegenüber dem ersten Leitermuster (13; 23) elektrisch isoliert ist, wobei der Kondensator (15; 25) in Reihe zwischen das erste Leitermuster (13; 23) und das zweite Leitermuster (14; 24) geschaltet ist,
wobei das Entstörfilter (10; 20) so montiert ist, dass die Ebene des Substrats senkrecht zu der Welle (34) des Motors (30; 50) ist, und zwar entweder in Nuten, die im Lagerschild (38) des Motors (30; 50) ausgebildet sind, oder an Abschnitten des Gehäuses (51), die von einem axialen Ende (51) nach innen vorstehen und am Lagerschild (58) des Motors.

2. Motor (30; 50) nach Anspruch 1, wobei das Entstörfilter (10; 20) eine Vielzahl der Kondensatoren (15; 25) umfasst.

3. Motor (30; 50) nach einem der Ansprüche 1 oder 2, wobei das erste Leitermuster und das zweite Leitermuster auf konzentrischen Kreisen so angeordnet sind, dass sie das Durchgangsloch umgeben.

4. Motor (30; 50) nach Anspruch 1, wobei das Entstörfilter (20) wie folgt aufgebaut ist:
das Substrat (21) ist mit zwei der Durchgangslöcher (22a; 22b) versehen und weist zwei Gruppen der ersten Leitermuster (23a; 23b) und der zweiten Leitermuster (24a; 24b) auf,
ein erster Kondensator (25a) ist in Reihe zwischen das erste Leitermuster (23a) und das zweite Leitermuster (24a) in einer Gruppe geschaltet, und
ein zweiter Kondensator (25b) ist in Reihe zwischen das erste Leitermuster (23b) und das zweite Leitermuster (24b) in der anderen Gruppe geschaltet.

5. Motor (30; 50) nach Anspruch 4, wobei das Entstörfilter (20) des Weiteren einen Kondensator (25c) umfasst, der in Reihe zwischen das erste Leitermuster (23a) in der einen Gruppe und das erste Leitermuster (23b) in der anderen Gruppe geschaltet ist.

## Revendications

1. Moteur (30 ; 50) comprenant un filtre de bruit (10 ; 20), **caractérisé en ce que**
le filtre de bruit (10 ; 20) comprend un substrat plan (11 ; 21) comportant un trou débouchant (12 ; 22) pour laisser passer une ligne d'alimentation électrique (40), et un condensateur (15 ; 25) placé sur le substrat, dans lequel le substrat possède :
un premier tracé conducteur (13 ; 23) situé près du trou débouchant (12 ; 22) et agencé pour être connecté électriquement à la ligne d'alimentation électrique (40) pour traverser le trou débouchant (12 ; 22), et
un second tracé conducteur (14 ; 24) électriquement isolé du premier tracé conducteur (13 ; 23) ; dans lequel le condensateur (15 ; 25) est connecté en série entre le premier tracé conducteur (13 ; 23) et le second tracé conducteur (14 ; 24),
dans lequel le filtre de bruit (10 ; 20) est monté de manière telle que le plan du substrat soit perpendiculaire à l'arbre (34) du moteur (30 ; 50), dans des sillons formés dans le support d'extrémité (38) du moteur (30 ; 50), ou sur des parties du boîtier (51) qui font saillie vers l'intérieur à partir d'une extrémité axiale du boîtier (51) et sur le support d'extrémité (58) du moteur.

2. Moteur (30 ; 50) selon la revendication 1, dans lequel le filtre de bruit (10 ; 20) comprend une pluralité desdits condensateurs (15 ; 25).

3. Moteur (30 ; 50) selon l'une quelconque des revendications 1 ou 2, dans lequel le premier tracé conducteur et le second tracé conducteur sont disposés sur des cercles concentriques de façon à entourer le trou débouchant.

4. Moteur (30 ; 50) selon la revendication 1, dans lequel le filtre de bruit (20) est configuré comme suit :
le substrat (21) comporte deux dits trous débouchants (22a ; 22b), et possède deux jeux de dits premiers tracés conducteurs (23a ; 23b) et dits seconds tracés conducteurs (24a ; 24b),
un premier condensateur (25a) est connecté en série entre le premier tracé conducteur (23a) et le second tracé conducteur (24a) dans un premier jeu, et
un second condensateur (25b) est connecté en série entre le premier tracé conducteur (23b) et le second tracé conducteur (24b) dans l'autre jeu.

5. Moteur (30 ; 50) selon la revendication 4, dans lequel le filtre de bruit (20) comprend en outre un condensateur (25c) connecté en série entre le premier tracé conducteur (23a) dans le premier jeu et le premier tracé conducteur (23b) dans l'autre jeu.
